(19) Europäisches Patentamt
European Patent Office
Office européen des brevets

(11) Veröffentlichungsnummer: **0 206 983**
**A2**

(12) **EUROPÄISCHE PATENTANMELDUNG**

(21) Anmeldenummer: **86810214.6**

(22) Anmeldetag: **16.05.86**

(51) Int. Cl.⁴: **G 03 F 7/10**, C 08 G 85/00, C 08 F 2/00, C 08 G 8/28

(30) Priorität: **22.05.85 GB 8512998**

(43) Veröffentlichungstag der Anmeldung: **30.12.86 Patentblatt 86/52**

(84) Benannte Vertragsstaaten: **BE CH DE FR GB IT LI NL SE**

(71) Anmelder: **CIBA-GEIGY AG, Klybeckstrasse 141, CH-4002 Basel (CH)**

(72) Erfinder: **Irving, Edward, Dr., 41, Swaffham Road, Burwell Cambridge CB5 0AN (GB)**
Erfinder: **Müller, Beat, Dr., Chemin des Cossettes 7, CH-1723 Marly (CH)**
Erfinder: **Schulthess, Adrian, Dr., Imp. des Cimes 1, CH-1752 Villars-sur-Glâne (CH)**
Erfinder: **Hunziker, Max, Dr., Bösingenfeldstrasse 34, CH-3178 Bösingen (CH)**

(54) **Verfahren und Polymere zur Bilderzeugung.**

(57) Polymer mit einem Molekulargewicht von mindestens 500, welches mindestens eine Gruppe der Formel I enthält

$$(-L^1-)_m Ar^1[X]-OSO_2-Ar^2(-L^2-)n \qquad (I)$$

worin einer der Indices m und n 1 ist und der andere 0 oder 1 bedeutet und X eine Gruppe der Formel II

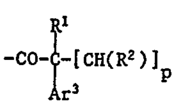

(II)

bedeutet, welche über die Carbonylgruppe an ein C-Atom der Gruppe $Ar^1$ verknüpft ist, oder X eine Gruppe der Formel III ist

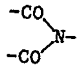

(III)

welche über die beiden Carbonylgruppen mit dem Rest $Ar^1$ verknüpft ist, und p 0 oder 1 bedeutet, und $R^1$, falls p 0 ist, Wasserstoff oder eine einwertige aliphatische, araliphatische oder aromatische Gruppe ist, und $R^1$, falls p 1 ist, Wasserstoff, $-OH$, oder eine veretherte $-OH$ Gruppe, eine Acyloxygruppe, Alkyl oder Phenylalkyl bedeutet, und $R^2$ Wasserstoff oder eine einwertige aliphatische, cycloaliphatische, heterocyclische, aromatische oder araliphatische Gruppe bedeutet, und $Ar^1$ eine ein-, zwei- oder dreiwertige aromatische Gruppe ist, und $Ar^2$ eine ein- oder zweiwertige aromatische Gruppe ist und $Ar^3$ eine einwertige aromatische Gruppe bedeutet und $L^1$ und $L^2$ unabhängig voneinander $-CO-$, $-COO-$, $-CONH-$, $-OCOO-$, $-NHCONH-$, $-OCONH-$, $-CSS-$, $-OCSS-$, $-OSO_2-$, $-CH_2-$, $-CH=$, $-O-$, $-S-$ oder $-N=$ bedeuten.

Diese Polymere, welche sich aus teilweise neuen Zwischenprodukten auf an sich bekannte Weise herstellen lassen, eignen sich zur Herstellung von Bildern, welche durch Bestrahlung mit aktinischen Strahlen und anschliessender Entwicklung mit wässerigen Basen erhalten werden.

EP 0 206 983 A2

CIBA-GEIGY AG
Basel (Schweiz)

3-15352/+/ARL 361

## Verfahren und Polymere zur Bilderzeugung

Die vorliegende Erfindung betrifft ein Verfahren zur Bilderzeugung, dabei einsetzbare Polymere, sowie Zwischenprodukte und Monomere, die zur Herstellung der Polymeren notwendig sind.

Bei der Bilderzeugung mittels positiver Photolacke werden die aktinischer Bestrahlung ausgesetzten Stellen des Lacks in einem Entwickler löslicher oder mindestens leichter entfernbar als die nicht bestrahlten Stellen. Beim Entfernen der belichteten Stellen mit dem Entwickler, der die nicht belichteten Stellen intakt lässt, entsteht ein positives Bild.

Im Handel erhältliche positive Photolack-Zusammensetzungen enthalten im allgemeinen neben einem filmbildenden organischen Material ein o-Naphthochinondiazid, das sich bei der Bestrahlung mit aktinischem Licht unter Freisetzung von Stickstoff und unter Bildung einer Indencarbonsäure zersetzt. Das filmbildende organische Material ist im allgemeinen ein alkali-lösliches Phenol-Formaldehyd-Novolakharz. Dessen Lösung in wässriger alkalischer Lösung wird durch das Naphthochinondiazid gehemmt; wenn sich jedoch das Diazid in den mit aktinischem Licht bestrahlten Bereichen zersetzt, vermindert sich dessen Wirksamkeit als die Lösung hemmendes Mittel, und die belichteten Stellen der Beschichtung werden in basischen Entwicklern löslicher als die nicht belichteten Stellen. Chinondiazide sind wegen ihrer thermischen Unbeständigkeit nicht ganz zufriedenstellend. Selbst unter Schutz gegen aktinische Strahlung zersetzten sie sich bei mässig erhöhten Temperaturen, und es werden dabei Bilder mit geringerer Qualität erhalten. Ausserdem werden relativ

hohe Mengen dieser Diazide als lösungshemmende Mittel benötigt. Da sie in dem bevorzugten tiefen UV-Bereich stark absorbieren, sind solche Diazide enthaltende Stoffgemische gegenüber Strahlung in diesem Bereich relativ opak und können nicht in die Tiefe, z.B. bis zur Oberfläche des Trägermaterials entwickelt werden, weil die Strahlung nicht tief genug in die Beschichtung eindringt.

Aus den US-PS 4,411,823 und 4,510,290 sind monomere Substanzen bekannt, welche photosensitive Sulfonyloxygruppen-haltige Reste enthalten. Diese Sulfonyloxygruppen sind über den Sauerstoff an ein aliphatisches C-Atom gebunden, welches seinerseits in α- oder β-Stellung zu einer Carbonylgruppe in α- oder β-Stellung zu einer aromatischen Gruppe steht.

Aus der US-PS 4,258,121 sind monomere Verbindungen bekannt, die eine N-Sulfonyloxyimidgruppe enthalten, welche über die Carbonylgruppe oder das Schwefelatom direkt am aromatischen Ring gebunden ist.

Diese bekannten photosensitiven Verbindungen sind als Vernetzungsmittel für Harze wie Aminoplaste und Phenolaldehyd-Resole, sowie als Radikalbildner für die Photopolymerisation von ethylenisch ungesättigten Materialien beschrieben worden.

Es wurde nun gefunden, dass die Löslichkeit bestimmter Polymerer in wässrigen basischen Entwicklern an den belichteten Stellen nach Bestrahlung mit aktinischen Licht erhöht werden kann.

Diese organischen Polymere, mit photosensitiven Resten, enthalten, (a) eine über Sauerstoff an ein aliphatisches C-Atom gebundene Sulfonyloxygruppe, wobei das C-Atom in α- oder β-Stellung zu einer Carbonylgruppe steht, welche ihrerseits in α- oder β-Stellung zu einer aromatischen Gruppe steht, oder (b) eine über die Carbonylgruppe oder das Schwefelatom direkt an die aromatische Gruppe verknüpfte Sulfonyloxyimidgruppe.

Die vorliegende Erfindung betrifft daher ein Verfahren zur Erzeugung von Bildern, dadurch gekennzeichnet, dass man

(i) eine Schicht eines organischen Polymers enthaltend photosensitive Reste, welche (a) eine über Sauerstoff an ein aliphatisches C-Atom gebundene Sulfonyloxygruppe enthalten, wobei das C-Atom in α- oder β-Stellung zu einer Carbonylgruppe steht, welche ihrerseits in α- oder β-Stellung zu einer aromatischen Gruppe steht, oder (b) eine über die Carbonylgruppe oder das Schwefelatom direkt an die aromatische Gruppe verknüpfte Sulfonyloxyimidgruppe enthalten,
in einem vorgegebenen Muster mit aktinischem Licht bestrahlt, wodurch das Polymer an den belichteten Stellen in wässrigen basischen Entwicklern löslicher wird als an unbelichteten Stellen, und

(ii) das Polymer an den bestrahlten Stellen durch Behandlung mit dem wässrigen basischen Entwickler entfernt.

Die vorliegende Erfindung betrifft ein photosensitives organisches Polymer mit einem Molekulargewicht von mindestens 500, welches mindestens eine Gruppe der Formel I enthält

$$(-L^1-)_m Ar^1[X]-OSO_2-Ar^2(-L^2-)_n \qquad (I)$$

worin einer der Indices m und n 1 ist und der andere 0 oder 1 bedeutet und X eine Gruppe der Formel II

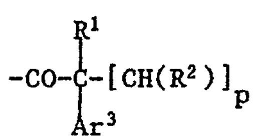

(II)

bedeutet, welche über die Carbonylgruppe an ein C-Atom der Gruppe $Ar^1$ verknüpft ist, oder X eine Gruppe der Formel III ist

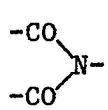

(III)

welche über die beiden Carbonylgruppen mit dem Rest $Ar^1$ verknüpft ist, und p 0 oder 1 bedeutet, und $R^1$, falls p 0 ist, Wasserstoff oder eine einwertige aliphatische, araliphatische oder aromatische Gruppe ist, und $R^1$, falls p 1 ist, Wasserstoff, -OH, oder eine veretherte -OH Gruppe, eine Acyloxygruppe, Alkyl oder Phenylalkyl bedeutet, und $R^2$ Wasserstoff oder eine einwertige aliphatische, cycloaliphatische, heterocyclische, aromatische oder araliphatische Gruppe bedeutet, und $Ar^1$ eine ein-, zwei- oder dreiwertige aromatische Gruppe ist, und $Ar^2$ eine ein- oder zweiwertige aromatische Gruppe ist und $Ar^3$ eine einwertige aromatische Gruppe bedeutet und $L^1$ und $L^2$ unabhängig voneinander -CO-, -COO-, -CONH-, -OCOO-, -NHCONH-, -OCONH-, -CSS-, -OCSS-, $-OSO_2-$, $-CH_2-$, -CH=, -O-, -S- oder -N= bedeuten. Falls m und n beide 1 sind, ergeben sich bevorzugte Kombinationen von $L^1$ und $L^2$ aus den Beispielen zu Formel XVI und XVII.

Bedeutet in der Formel I das Symbol X eine Gruppe der Formel II, so sind bevorzugte Polymere solche, in welchen p 0 bedeutet, $R^1$ Wasserstoff, $C_1$-$C_8$ Alkyl, welches unsubstituiert oder mit -OH, -Cl, -CN, $C_1$-$C_4$ Alkoxy, $C_2$-$C_5$ Alkoxycarbonyl, Phenyl, Chlorphenyl, $C_7$-$C_{10}$ Alkylphenyl oder $C_7$-$C_{10}$ Alkoxyphenyl substituiert ist, ferner Phenyl, welches unsubstituiert oder mit -Cl, -$C_1$-$C_4$ Alkyl, $C_1$-$C_4$ Alkoxy oder $C_1$-$C_4$ Alkylthio substituiert ist, ferner Benzoyl, $C_2$-$C_8$ Alkoxycarbonyl, $C_1$-$C_4$ Alkyl-NHCO-, Phenyl-NHCO-, $-CONH_2$ oder -CN und $Ar^1$ und $Ar^2$ unabhängig voneinander eine ein- oder zweiwertige aromatische Gruppe mit 6-30 C-Atomen ist, wobei mindestens eine der Gruppen $Ar^1$ oder $Ar^2$ zweiwertig ist, und $Ar^3$ Phenyl, welches unsubstituiert oder mit -Cl, $C_1$-$C_4$ Alkyl, $C_1$-$C_4$ Alkoxy oder $C_1$-$C_4$ Alkylthio substituiert ist.

Besonders bevorzugt sind Polymere enthaltend mindestens eine Gruppe der Formel I worin X eine Gruppe der Formel II ist, p 0 bedeutet und $R^1$ Wasserstoff oder $C_1$-$C_4$ Alkyl ist, und $Ar^1$ und $Ar^2$ Phenyl oder Phenylen bedeutet, und mindestens eines von $Ar^1$ und $Ar^2$ Phenylen ist, und $Ar^3$ Phenyl bedeutet.

Ausserdem werden Polymere bevorzugt, welche mindestens eine Gruppe der Formel I enthalten, worin X eine Gruppe der Formel II ist, p 1 bedeutet, und $R^1$ Wasserstoff, -OH, $C_1$-$C_4$ Alkoxy, Acetyloxy, $C_1$-$C_8$ Alkyl oder $C_7$-$C_{14}$ Phenylalkyl ist, $R^2$ Wasserstoff, $C_1$-$C_8$ Alkyl, welches unsubstituiert oder mit -OH, -Cl oder Phenyl substituiert ist, oder ferner Phenyl, welches unsubstituiert oder mit -OH, -Cl, $C_1$-$C_4$ Alkyl, $C_1$-$C_4$ Alkoxy substituiert ist, oder $R^2$ ausserdem $C_2$-$C_6$ Alkenyl, $C_8$-$C_9$ Phenylalkenyl, Furyl, $C_5$-$C_6$ Cycloalkyl oder $C_5$-$C_6$ Cycloalkenyl ist, und $Ar^1$ und $Ar^2$ unabhängig voneinander eine ein- oder zweiwertige Gruppe mit 6-30 C-Atomen ist, und mindestens eine der Gruppen $Ar^1$ oder $Ar^2$ zweiwertig ist, und $Ar^3$ Phenyl, welches unsubstituiert oder mit -Cl, $C_1$-$C_4$ Alkyl, $C_1$-$C_4$ Alkoxy oder $C_1$-$C_4$ Alkylthio substituiert ist.

Besonders bevorzugt sind unter diesen Polymeren, in denen in der Formel I X eine Gruppe der Formel II und p 1 bedeutet, solche, worin $R^1$ -OH, $C_1$-$C_4$ Alkyl oder $C_1$-$C_4$ Alkoxy und $R^2$ Wasserstoff oder $C_1$-$C_4$ Alkyl sind, und $Ar^1$ und $Ar^2$ unabhängig voneinander Phenyl, Naphtyl, Phenylen oder Naphtylen sind, welche unsubstituiert oder mit -Cl, -Br, -CN, $-NO_2$, $C_1$-$C_{12}$ Alkyl, $C_1$-$C_4$ Alkoxy oder $C_1$-$C_8$ Alkylthio substituiert sind und mindestens eines von $Ar^1$ und $Ar^2$ unsubstituiertes oder substituiertes Phenylen oder Naphtylen bedeutet.

Spezielle Erwähnung verdienen Polymere welche Gruppen der Formel I enthalten, worin X eine Gruppe der Formel II ist und p 1 bedeutet, und $R^1$ -OH oder $C_1$-$C_4$ Alkoxy ist, und $R^2$ für Wasserstoff steht, und $Ar^1$ und $Ar^2$ unabhängig voneinander Phenyl oder Phenylen sind und mindestens eines von $Ar^1$ und $Ar^2$ Phenylen ist, und $Ar^3$ Phenyl bedeutet.

In speziell bevorzugten Polymeren, die Reste der Formel I enthalten, sind solche, worin X eine Gruppe der Formel II ist, bedeutet bevorzugt einer der Indices m oder n null, und der andere 1.

In spezifisch bevorzugten Polymeren dieser Art entsprechen die Gruppen der Formel I der Formel IV

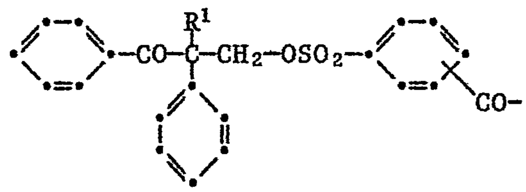

(IV)

worin $R^1$ -OH oder $C_1$-$C_4$ Alkoxy ist und die Carbonylgruppe mit der freien Valenz bevorzugt in para-Stellung zur Sulfonyloxygruppe steht.

Bedeutet in der Formel I das Symbol X eine Gruppe der Formel III, so handelt es sich bevorzugt um Verbindungen, worin $Ar^1$ eine zweiwertige und, falls m 1 ist, eine dreiwertige aromatische Gruppe mit 6-30 C-Atomen, und $Ar^2$ eine ein- oder zweiwertige aromatische Gruppe mit 6-30 C-Atomen darstellt.

Bevorzugte Verbindungen dieser Art sind solche, worin $Ar^1$ o-Phenylen, 1,2-, 2,3- oder 1,8-Naphtylen oder Benzol-1,2,3-, -1,2,4-, -1;2,5- oder -1,2,6-triyl bedeutet, wobei diese Reste unsubstituiert oder mit -Cl, -Br, $-NO_2$, $-C_1$-$C_8$ Alkyl, $C_1$-$C_4$ Alkoxy, $C_1$-$C_{12}$ Alkylthio oder Phenylthio substituiert sind, und $Ar^2$ für Phenyl, m- oder p-Phenylen, Naphtyl oder 1,2-, 2,3- oder 1,8-Naphtylen steht, wobei diese Reste substituiert oder mit -Cl, -Br, $-NO_2$, $C_1$-$C_{15}$ Alkyl, $C_1$-$C_4$ Alkoxy, $C_1$-$C_4$ Alkyl-CONH oder Phenyl-CONH substituiert sind.

Unter den genannten Resten sind für $Ar^1$ besonders o-Phenylen, 1,8-Naphtylen und Benzol-1,2,4-triyl und für $Ar^2$ besonders Phenyl, p-Tolyl, m- oder o-Phenylen zu erwähnen.

In den besonders bevorzugten Polymeren, welche als X eine Gruppe der Formel III besitzen, bedeutet einer der Indices m und n 0 und der andere 1. Spezifische Gruppen der Formel I sind z.B.

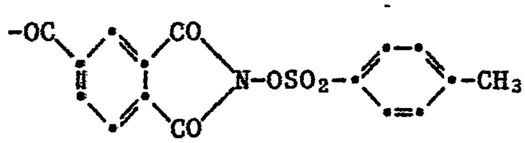

(V)

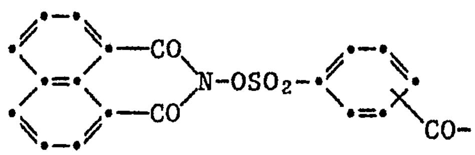

(VI)

oder

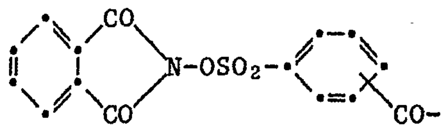

(VII)

wobei die Carbonylgruppe mit der freien Valenz in den Formeln VI und VII in m- oder p-Stellung stehen.

Eine andere Klasse bevorzugter Polymerer sind solche, in welchen einer der Indices m und n 0 und der andere 1 bedeutet, und somit die Gruppe der Formel I einwertig ist. Solche Gruppen sind entweder direkt oder durch ein Brückenglied an die Polymerkette geknüpft. Solche Polymere können wenig oder vernachlässigbar löslich in wässrigen Basen sein, aber längs der Polymerkette verschiedene reaktive Stellen wie z.B. Hydroxygruppen besitzen, welche die Einführung mehrerer photosolubilisierender Reste durch Reaktion mit Verbindungen, die reaktive Gruppen, wie z.B. Carboxylgruppen oder einen Rest der Formel I enthalten, erlauben. Als Beispiel sei ein hochmolekulares oder vorverlängertes Epoxidharz erwähnt, das sich von Bisphenol oder einem Polyol ableitet und mehrere sekundäre Hydroxygruppen längs der Polymerkette besitzt. Vorzugsweise aber ist das Polymer, an welches die Gruppen der Formel I gebunden sind, löslich in wässrigen Basen.

Geeignete lösliche Polymere sind insbesondere Hydroxygruppen-haltige Additions- und Kondensationspolymere, wie Polyvinylalkohol, Polyvinylphenol, phenolische Novolakharze, sowie Carboxylgruppen-haltige oder Carbonsäureanhydrid-haltige Additions- oder Kondensationspolymere, wie Homo- und Copolymere der Acryl- und Methacrylsäure, Polybutadiene mit Carboxylendgruppen, sowie Homo-und Copolymere von Maleinsäureanhydrid und Polyestern mit Carboxylendgruppen.

Enthält das in wässriger Base lösliche Polymer Hydroxygruppen, so kann das photosensitive Polymer erhalten werden, indem man das Polymer mit einer Carbonsäure der Formel IX

$$(HOOC)_x-AR^1-[X]-OSO_2-Ar^2-(COOH)_y \qquad (IX),$$

oder einem Derivat davon, umsetzt, wobei einer der Indices x und y 0 und der andere 1 bedeutet und die Symbole X, $Ar^1$ und $Ar^2$ die oben angegebene Bedeutung haben. Geeignete Derivate der Verbindungen der Formel IX sind die Säurechloride und die Niederalkyl- oder Glycidylester.

Enthält das in wässriger Base lösliche Polymer Carboxylgruppen, so kann das photosensitive Polymer erhalten werden, indem man das Polymer mit dem Glycidylester einer Verbindung der Formel IX umsetzt oder indem man die Carboxylgruppen im Polymer in die entsprechenden Säurechlorid-gruppen überführt und diese mit einem Hydroxyalkylester einer Verbindung der Formel IX umsetzt.

Andere photosensitive Polymere, welche einen einwertigen Rest der Formel I an der Polymerkette enthalten, können erhalten werden, indem man einen Acrylat- oder Methacrylgruppen-haltigen Ester einer Verbindung der Formel IX mit einer ethylenisch ungesättigten Säure copolymerisiert. Solche Acrylat- oder Methacrylatgruppen-haltigen Ester können hergestellt werden, indem man eine Säure der Formel IX oder ein reaktionsfähiges Derivat davon mit einem Glycidyl-acrylat oder -methacrylat umsetzt, oder eine Acryl- oder Methacrylsäure mit dem Glycidylester einer Säure der Formel IX umsetzt.

Besonders bevorzugte photosensitive Polymere sind insbesondere solche, in welchen der Rest der Formel I über ein Sauerstoffatom mit der Polymerkette verbunden ist. Zu diesen gehören phenolische Novolakharze, worin mindestens 4 % der phenolischen Hydroxylgruppen durch eine Gruppe der Formel -OY ersetzt sind, wobei Y einen Rest der Formel I darstellt, worin einer der Indices m und n 0 und der andere 1 bedeutet. Geeignete Novolakharze entsprechen der Formel

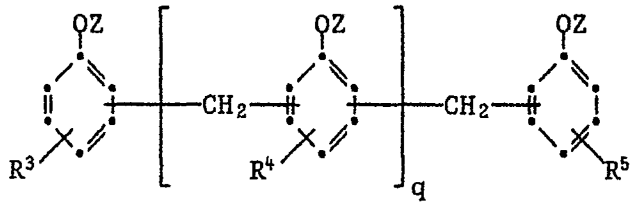

(X),

worin Z Wasserstoff oder Y bedeutet, und mindestens 4 % aller Reste Z per Molekül Y bedeuten, $R^3$, $R^4$ und $R^5$ unabhängig voneinander Wasserstoff, Chlor, Brom, $C_1$-$C_{10}$ Alkyl, $C_7$-$C_{20}$ Aralkyl, Acetyl, Benzoyl, Carboxyl, verestertes Carboxyl oder -OZ bedeuten, und q eine ganze Zahl von 1 bis 20 ist.

Bevorzugt bedeuten mindestens 7 % aller Reste Z die Gruppe der Formel I (Y), q ist eine Zahl von 1 bis 15 und $R^3$, $R^4$ und $R^5$ bedeuten Wasserstoff, eine o-, m- oder p-Methylgruppe, eine o-, m-oder p-t.Butylgruppe oder eine o-, m- oder p-Octylgruppe.

Die photosensitiven Novolakharze können hergestellt werden, indem man ein Novolakharz, welches sich vorzugsweise von Formaldehyd und einem Phenol, einem Kresol, einem t.Butylphenol, einem Octylphenol oder einem Gemisch zweier oder mehrerer der genannten Phenole ableitet, mit einer Säure der Formel IX oder einem reaktionsfähigen Derivat davon, bevorzugt einem Säurechlorid, umsetzt.

Besonders bevorzugte photosensitive Novolakharze, sind diejenigen, bei denen in der Formel X 7-25 % aller Reste Z durch Gruppen der Formel I ersetzt sind, in der X eine Gruppe der Formel IV, V, VI oder VII darstellt, und in denen einige der Reste $R^3$, $R^4$ und $R^5$ Wasserstoff, die anderen p-tert.Butyl bedeuten.

In weiteren bevorzugten photosensitiven Polymeren sind die Gruppen der Formel I über ein Brückenglied der Formel $-OR^6OCO-$ an ein C-Atom der Polymerkette gebunden, wobei $R^6$ $C_1$-$C_8$ Alkylen bedeutet, welches durch eine Hydroxylgruppe substituiert sein kann. Beispielsweise handelt es sich dabei um Copolymere erhältlich aus

(a) einem Monomeren der Formel XI

$CH_2=C(R^7)COOR^6-OY$ (XI)

worin $R^7$ Wasserstoff oder Methyl ist, und Y eine Gruppe der Formel I bedeutet, worin einer der Indices m und n 0 und der andere 1 ist, und $R^6$ die oben angegebene Bedeutung hat, und

(b) einer polymerisierbaren ethylenisch ungesättigten Säure und gegebenenfalls

(c) einem weiteren ethylenisch ungesättigten Monomer.

Solche Copolymere enthalten z.B. 20-70 Gew.%, vorzugsweise 25-60 Gew.% der Komponente (a), 5-30 Gew.%, vorzugsweise 10-20 Gew.% der Komponente (b) und 0-70 Gew.%, vorzugsweise 30-60 Gew.% der Komponente (c).

Die ungesättigte Säure (b) ist beispielsweise eine Sulfonsäure wie Vinylsulfonsäure, ist aber vorzugsweise eine ungesättigte Carbonsäure, wie eine Acryl- oder Methacrylsäure, oder einem Carboxylgruppen-haltigen Addukt eines Hydroxyalkyl-Acrylats oder -Methacrylats mit einem Polycarbonsäureanhydrid, wie Succinsäure-, Glutarsäure-, Maleinsäure-, Phthalsäure- oder Trimellitsäure-Anhydrid. Besonders bevorzugte Säuren (b) sind Acrylsäure und Methacrylsäure.

Ist auch eine Komponente (c) vorhanden, so handelt es sich beispielsweise um einen Ester der Acryl- oder Methacrylsäure, z.B. um Ethylacrylat oder Methylmethacrylat, ein Vinylhalogenid, wie Vinylchlorid, einen Vinylester, wie Vinylacetat, oder eine Vinylaromatische Verbindung, wie Styrol, α-Methylstyrol oder p-Bromstyrol. Bevorzugt ist Methylmethacrylat.

Bevorzugte Copolymere werden hergestellt aus (a) einem Monomer der Formel XI, (b) Acryl- oder Methacrylsäure, und (c) Methylmethacrylat.

In den Monomeren der Formel XI bedeutet $R^6$ bevorzugt Methylen, Ethylen oder 2-Hydroxytrimethylen. Bevorzugt wird Ethylen. Y bedeutet bevorzugt einen Rest der Formel IV, V, VI oder VII.

Diese Copolymere werden nach üblichen Methoden hergestellt, z.B. durch radikalische Polymerisation, in Gegenwart eines Peroxids, Hydroperoxids oder einer Azoverbindung als Initiator. So werden die Komponenten (a), (b) und gegebenenfalls (c) durch Erhitzen in Lösung oder Suspension in einem organischen Lösungmittel in Gegenwart eines Initiators copolymerisiert.

Die Monomeren der Formel XI können hergestellt werden, indem man eine Säure der Formel IX, oder das entsprechende Säurechlorid mit einem Hydroxyalkyl-acrylat oder -methacrylat umsetzt, oder indem man eine Säure der Formel IX mit einem Glycidylacrylat oder -methacrylat reagieren lässt, oder aber eine Acryl- oder Methacrylsäure mit einem Glycidylester einer Säure der Formel IX umsetzt. Alle diese Reaktionen werden unter üblichen Veresterungsbedingungen durchgeführt.

Die Carbonsäuren der Formel IX, welche als Zwischenprodukte bei der Herstellung der photosensitiven Polymeren dienen, können mit der Formel XII dargestellt werden

$$(HOOC)_m Ar^1-[X]-OSO_2-Ar^2-(COOH)_n \qquad (XII)$$

worin einer der Indices m und n 0 oder 1 ist, und der andere 1 bedeutet, und $Ar^1$, $Ar^2$ und X die oben angegebene Bedeutung haben. Verbindungen der Formel XII, worin X eine Gruppe der Formel II bedeutet, sind neu und stellen daher auch einen Gegenstand vorliegender Erfindung dar, ebenso die Verbindung der Formel XII, worin m und n 1 sind, oder worin m 0 ist und n 1 bedeutet und X eine Gruppe der Formel III bedeutet.

Falls X eine Gruppe der Formel II ist, so können die Säuren der Formel XII hergestellt werden, indem man ein aromatisches Sulfonylchlorid der Formel

$Cl-SO_2-Ar^2-(COOH)_n$ (XIII)

worin n 0 oder 1 ist, entweder mit einem Benzoin der Formel

$(HOOC)_mAr^1-CO-CH(OH)-Ar^3$ (XIV)

oder einem substituierten oder unsubstituierten Methylolbenzoin der Formel

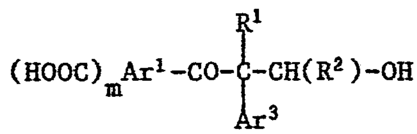 (XV)

worin m 0 oder 1 ist, $Ar^3$ eine einwertige aromatische Gruppe ist, und $R^1$ und $R^2$ wie in Formel II definiert ist, falls p 1 ist, bedeutet.

Diese Reaktion kann nach den üblichen Methoden durchgeführt werden, die angewandt werden, wenn Sulfonylchloride mit Hydroxy-Verbindungen umgesetzt werden.

Acrylat- und Methacrylatgruppenhaltige Ester der Formel XII, worin X eine Gruppe der Formel II bedeutet, können, statt aus den entsprechenden Säuren wie eben beschrieben wurde, durch Ueberführung eines carboxylhaltigen Sulfonylchlorids der Formel XIII (mit n=1) in das entsprechende Carbonsäurechlorid übergeführt werden, indem dieses Carbonsäurechlorid vorerst mit einem Hydroxyacrylat oder -methacrylat verestert wird, bevor dann die Sulfonylchloridgruppe mit einer Verbindung der Formel XIV oder XV umgesetzt wird.

Bedeutet X eine Gruppe der Formel III, so können die Säuren der Formel XII hergestellt werden, indem man ein N-Hydroxyimid der Formel

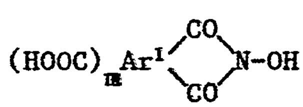 (XVI),

worin m 0 oder 1 ist, mit einem aromatischen Sulfonylchlorid der Formel XIII umsetzt. Diese Reaktion wird unter für die Umsetzung von Sulfonylchloriden mit Hydroxyverbindungen üblichen Bedingungen durchgeführt. So kann, falls das Sulfonylchlorid Carboxylgruppenfrei ist, die Reaktion in einem organischen Lösungsmittel in Gegenwart einer organischen Base, und falls das Sulfonylchlorid Carboxylgruppen enthält, in wässrigem alkalischem Milieu durchgeführt werden.

Wenn sowohl m als auch n 1 sind, d.h. wenn Formel I einen zweiwertigen Rest darstellt, können photoempfindliche Polymere hergestellt werden, die Einheiten der Formel I in der Hauptkette enthalten. Dabei ist es sowohl möglich, Einheiten der Formel I direkt untereinander zu verknüpfen oder aber unter Dazwischenschaltung von andern Comonomeren. Solche Polymere können mit einer niedrigen bzw. vernachlässigbaren Löslichkeit in wässriger Base dargestellt werden. Bei Belichtung mit aktinischer Strahlung werden die Polymerketten in kurze Stücke gespalten, die Sulfonsäuregruppen enthalten und damit wässrig-alkalisch löslich sind.

Solche Polymere können beispielsweise aus difunktionellen Resten der Formel

$$M^1\text{-}Ar^1\text{-}X\text{-}OSO_2\text{-}Ar^2\text{-}M^2 \qquad (XVII)$$

dargestellt werden, gegebenenfalls unter Einbezug von Comonomeren der Formel

$$N^1\text{-}R^8\text{-}N^2 \qquad (XVIII)$$

wobei X $Ar^1$ und $Ar^2$ die vorstehend beschriebene Bedeutung haben und $M^1$, $M^2$ stehen für: Amino, Alkylamino, Arylamino, Carboxyl, verestertes Carboxyl, Halogen, Aminocarboxyl (Amid bzw. substituiertes Amid), Alkylcarboxyl, Arylcarboxyl, verestertes Alkylcarboxyl bzw. Arylcarboxyl, Mercapto, Brommethyl, Chlormethyl, Chlorcarbonyl, Sulphoxychlorid, Alkyl- und Arylsulfoxychlorid, Glycidyl, Hydroxyl,

Alkyl- oder Arylhydroxyl, Isocyanate, Carbonyl, Alkylcarbonyl, Alkenylcarbonyl oder Arylcarbonyl, und $N^1$ und $N^2$ stehen für Amino, Carboxyl oder verestertes Carboxyl, Chlorcarbonyl, Chlorcarboxyl, Halogen, Hydroxy, Mercapto, Glycidyl, Isocyanato, Sulphoxychlorid, Carbonyl sowie $R^8$ für Alkylen, Arylen, Aryldialkylen, $>C=O$, $>C=S$, $>Si(C_6H_5)_2$, $>Si(CH_3)_2$ wobei $M^1$ und $M^2$ sowie $N^1$ und $N^2$ je gleich oder verschieden sein können, je nach gewünschtem Polymer.

Werden beispielsweise difunktionelle Verbindungen der Formel XVII ohne Einbezug von Comonomeren zu Polymeren kondensiert, dann ergeben sich für $M^1$ und $M^2$ die folgenden Möglichkeiten:

- falls $M^1$ steht für $NH_2$, OH oder SH, kann $M^2$ mit Ausnahme von Amino, Alkyl- bzw. Arylamino, Hydroxyl, Alkyl- oder Arylhydroxyl und Mercapto jeden der aufgezählten Reste bedeuten;
- falls $M^1$ steht für Isocyanat (-NCO) dann kann $M^2$ z.B. Amino, Alkylamino, Arylamino, Hydroxyl, Alkyl- oder Arylhydroxyl, Mercapto oder $-CH_2Br$ bzw. $-CH_2Cl$ (in Form eines Grignard Reagens') bedeuten;
- steht $M^1$ für Carboxyl (-COOH) dann ergeben sich für $M^2$ die gleichen Möglichkeiten wie im Fall wo $M^1$=-NCO, jedoch kann $M^2$ zusätzlich noch Glycidyl bedeuten;
- steht $M^1$ für ein Carbonsäurederivat der Form -COCl, -COOR, $-CONH_2$, $CONR_2$, oder für $-SO_2Cl$, Brom, Chlor oder $-CH_2Br$ bzw. $-CH_2Cl$, dann hat $M^2$ die Bedeutung Amino, Alkylamino, Arylamino, Hydroxyl, Alkyl- oder Arylhydroxyl und Mercapto.
- Werden Comonomere gemäss Formel XVIII mit Verbindungen der Formel XVII polykondensiert, so sind bevorzugt je $M^1$ und $M^2$ sowie $N^1$ und $N^2$ gleich. Damit ergeben sich dieselben Kombinationsmöglichkeiten wie sie für $M^1$ und $M^2$ vorstehend beschrieben wurden.

Falls $M^1$ und $M^2$ in Formel XVII bzw. $N^1$ und $N^2$ in Formel XVIII je ungleich sind, so werden Beispiele bevorzugt, in denen $M^1$ und $N^1$ bzw. $M^2$ und $N^2$ je gleich sind. Auch in diesem Fall ergeben sich die Kombinationsmöglichkeiten wie sie bereits für $M^1$ und $M^2$ vorstehend

beschrieben wurden. Dabei ist es für den Fachmann auf dem Gebiet der Polykondensationen ein leichtes, geeignete Kombinationen auszuwählen.

Polymere der beschriebenen Art können andererseits auch dargestellt werden indem man Verbindungen der Formel

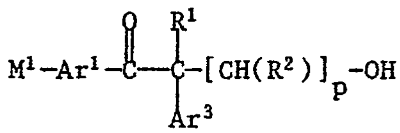

(XIX)

umsetzt mit Verbindungen der Formel XVIII, wobei $M^1$, $Ar^1$, $Ar^3$, $R^1$, $R^2$, $R^8$ und p die vorstehend genannte Bedeutung haben und $N^1$ und $N^2$ Sulphoxychlorid bedeuten.

In einer bevorzugten Klasse solcher Polymere geht man von 4-Aminobenzoin aus, dessen Herstellung aus 4-Nitrobenzil erfolgt, und führt die Polykondensation mit einem geeigneten Disulfonsäurechlorid durch. Geeignete Disulfonsäurechloride sind zum Beispiel Kondensationsprodukte von 3-Chlorsulphonylbenzoylchlorid mit aliphatischen oder aromatischen Diolen oder Chlorsulphonierungsprodukte von Bisarylen. Die so erhaltenen Kondensationsprodukte zeichnen sich durch hohe Molekulargewichte und gute filmbildende Eigenschaften aus und sind photostrukturierbar.

In einer besonders bevorzugten Klasse solcher Polymere setzt man 4-Aminobenzoin mit Kondensationsprodukten von 3-Chlorsulphonylbenzoylchlorid mit aliphatischen oder aromatischen Diolen um.

Ganz besonders bevorzugt sind Polymere aus 4-Aminobenzoin und Hexandiol-1,6-bis(3-chlorsulphonylbenzoesäureester), Benzoldimethanol-1,4-bis(3-chlorsulphonylbenzoesäureester) oder Chlorsulphonierungsprodukten von α,ω-Diphenoxyalkanen.

Weitere bevorzugte Polymere leiten sich von 4-Hydroxybenzoin ab, (J. Chem. Soc. 1966, 533) das mit Disulphonsäurechloriden zu Polysulphonaten kondensiert. Bevorzugte Disulphonsäurechloride sind die gleichen, die für Kondensationen mit 4-Aminobenzoin eingesetzt werden.

Eine weitere Klasse bevorzugter Polymerer leitet sich von Verbindungen der Formel XX ab,

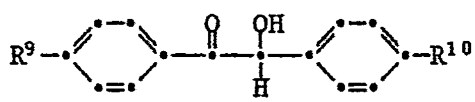 (XX)

wobei $R^9$ und $R^{10}$ -COOAlkyl, -COCl, -COOH, -N=C=O sein können, mit der Massgabe, dass entweder $R^9$ oder $R^{10}$ Wasserstoff sein muss, die mit aliphatischen oder aromatischen Diolen oder Diaminen zu Bisbenzoinen umgesetzt werden, die ihrerseits dann mit Disulphonsäurechloriden Polykondensate ergeben. Speziell bevorzugt sind dabei solche Polymere, die aus Verbindungen der Formel XX mit $R^7$ oder $R^8$ gleich -COOAlkyl abgeleitet werden.

Besonders bevorzugte Polymere erhält man auch, wenn 1,4-bis-(Phenylglyoxyloyl)-Benzol oder 1,3-bis-(Phenylglyoxyloyl)-Benzol mit Disulfonsäurechloriden zu Polysulfonaten kondensiert werden. Die Herstellung der Bisbenzoine verfolgt gemäss DOS 3019500.

Eine weitere bevorzugte Klasse von Polymeren geht aus Verbindungen der Formel XVII hervor, wobei X die Bedeutung gemäss Formel IV hat, $Ar^1$ und $Ar^2$ die vorstehend beschriebene Bedeutung haben und $M^1$ und $M^2$ für Carboxylreste stehen. Solche Dicarbonsäuren oder Dicarbonsäureester können mit Diolen oder Diaminen zu Polyestern respektive Polyamiden umgesetzt werden.

Werden die photosensitiven Polymere gemäss der vorliegenden Erfindung für die Bilderzeugung verwendet, so kann die Herstellung der Bilder beschleunigt werden, wenn das Polymer zusammen mit einem Photosensibilisator eingesetzt wird, d.h. mit einer Verbindung, welche unter Bestrahlung in einen angeregten Zustand übergehen und

die Energie auf die nicht angeregte latente Sulfonsäurequelle übertragen. Als Photosensibilisatoren kommen z.B. kondensierte aromatische Kohlenwasserstoffe und deren substituierte Derivate, aromatische Carbonylverbindungen, aromatische Nitroverbindungen und kationische oder basische Farbstoffe in Betracht. Spezifische Klassen geeigneter Photosensibilisatoren sind z.B. Anthracene, Fluranthene, Pyrene, Anthrone, Thioxanthone, wie das 2-Methyl- oder 2-Chlorthioxanthon, und Benzophenone, besonders Bis(dialkylamino)-benzophenon (Michler's Keton). Dem Stoffgemisch kann auch ein Farbstoff, wie z.B. Kristallviolett beigegeben werden, wodurch das Bild leichter erkennbar ist.

Bei der Ausführung des erfindungsgemässen Verfahrens kann eine Schicht des Stoffgemisches, aus dem das Bild erzeugt werden soll, in an sich bekannter Weise aus einem Lösungsmittel auf ein Trägermaterial appliziert werden. Als Lösungsmittel eignen sich z.B. 2-Ethoxyethanol, 2-Ethoxyethylacetat, Ethylmethylketon, N-Methylpyrrolidon, Dimethylformamid oder Gemische davon. Das Auftragen der Schicht kann durch Tauchen, Schleuderbeschichtung, Sprühen oder durch Walzenauftrag erfolgen. Anschliessend lässt man das Lösungsmittel verdampfen, oder das Lösungsmittel wird verdampft, z.B. durch Trocknen an der Luft oder durch Erhitzen auf Temperaturen unterhalb der Härtungstemperatur von hitzehärtbaren Bestandteilen. Als Trägermaterial werden im allgemeinen Kupfer, Aluminium oder andere Metalle, Silizium, Siliziumoxide oder -nitride, synthetische Harze oder Kunststoffe, wie Polyesterfilme, Polyamide, Polyolefine, Papier oder Glas verwendet. Die Beschichtung erfolgt zweckmässig so, dass nach dem Trocknen eine etwa 1-250 Mikrometer dicke Schicht entsteht.

Das Bestrahlen des Stoffgemisches mit aktinischem Licht in einem vorgegebenen Muster kann durch Belichten durch ein ein Bild aufweisendes transparentes Material, das aus im wesentlichen opaken und im wesentlichen transparenten Bereichen besteht, oder mit einem computergesteuerten Laserstrahl vorgenommen werden. Im allgemeinen wird aktinisches Licht mit 200-600 nm Wellenlänge verwendet. Als Lichtquellen eignen sich z.B. Kohlebögen, Quecksilberdampflampen,

Fluoreszierende Lampen mit ultraviolettem Licht emittierenden Phosphoren, Argon- und Xenonglühlampen, Wolframlampen und photographische Flutlichtlampen. Quecksilberdampflampen und Metallhalogenidlampen sind am besten geeignet. Die erforderliche Belichtungszeit hängt von verschiedenen Faktoren ab, wie der Art der verwendeten Zusammensetzung, der Schichtdicke, der Art der Lichtquelle und deren Abstand von der Schicht. Sie betragen im allgemeinen zwischen 30 Sekunden und 4 Minuten, die geeignete Zeit kann jedoch leicht mittels Routine-Versuchen ermittelt werden.

Nach der bildmässigen Belichtung wird die Schicht mit einem Entwickler behandelt, um die belichteten Stellen, herauszulösen. Die nicht bestrahlten Bereiche bleiben unverändert. Der Entwickler löst die bestrahlten Stellen oder macht sie leichter entfernbar durch sanftes Bürsten oder Schütteln.

Als wässriger basischer Entwickler können wässrige Lösungen einer starken organischen Base, wie Triethylamin, verwendet werden. Bevorzugt sind jedoch wässrige alkalische Lösungen, z.B. solche, die Natriumhydroxid, Natriumcarbonat oder Dinatriumhydrogenphosphat enthalten. Zur Beschleunigung des Entwicklungsvorganges können kleine Mengen, z.B. 5-15 Vol. %, eines mit Wasser mischbaren niederen aliphatischen Alkohols, wie Methanol, zugegeben werden.

Nach dem Belichten und Entwickeln kann das Substrat geätzt werden, um entweder bei der Herstellung von gedruckten Schaltungen das Metall von den belichteten Stellen zu entfernen, oder um die Bildtiefe und damit die Abhebung des Bildes zu vergrössern. Dabei schützt die verbleibende Beschichtung an den nicht bestrahlten Stellen das darunter liegende Substrat. Geeignete Aetzverfahren, z.B. unter Verwendung von Eisen(III)chlorid- oder Ammoniumpersulfat-Lösungen auf Kupfer, sind bekannt. Falls erwünscht, kann das ganze Substrat in nicht bildmässiger Weise während einer längeren Zeit noch einmal bestrahlt werden. Dabei wird die verbliebene Beschichtung in basischen Lösungen löslich und das darunter liegende Substrat wird freigelegt.

Falls der Träger metallisch ist, kann dieser nach dem Entwickeln mit einem Metall, wie Kupfer, Zinn, Blei oder Nickel beschichtet werden, die polymere Schicht wird entfernt, z.B. durch weitere Bestrahlung, und das so freigelegte Metall kann wie oben beschrieben geätzt werden.

Das erfindungsgemässe Verfahren eignet sich zur Herstellung von Druckplatten und gedruckten, integrierten oder Hydrid-Schaltungen.

In den folgenden Beispielen sind Teile Gewichtsteile, sofern nichts anderes angegeben ist. Alle in den verwendeten Polymere sind fest und haben ein Molekulargewicht von mindestens 500.

Beispiel 1: 100 g Trimellitsäureanhydrid werden zu 36,7 g Hydroxylamin-hydrochlorid in 250 ml Pyridin gegeben. Die Mischung wird gerührt und auf 90°C erhitzt, sobald eine Rotfärbung eintritt. Das Pyridin wird nach 1 Stunde bei 90°C unter Vacuum abdestilliert. Der Rückstand wird in 350 ml Wasser dispergiert und während dem Abkühlen mit 150 ml konzentrierter Salzsäure langsam versetzt. Nach 1 Stunde Rühren wird der ausgefallene Festkörper abfiltriert, mit Wasser gewaschen und aus 250 ml Aceton und 250 ml Wasser umkristallisiert, danach wird Wasser zugegeben und das Aceton abgedampft. Nach dem Abfiltrieren wird erneut mit Wasser gewaschen und das kristalline Produkt bei 110°C im Vakuum getrocknet. So werden 77 g N-Hydroxytrimellitsäureimid erhalten, welche bei 236-238° schmelzen.

30 g des so erhaltenen Produkts und 27,6 g p-Toluolsulfonylchlorid werden in 130 ml Acetonitril gelöst. Während 15 Minuten wird zu dieser Lösung 22,9 g Pyridin zugegeben. Nach 1 Stunde werden 20 g konzentrierte Salzsäure und danach 500 ml Wasser zugefügt. Der ausgefallene Niederschlag wird abfiltriert, mit Wasser gewaschen, in einem Wasser/Aceton-Gemisch aufgelöst und durch weiteres Zufügen von Wasser erneut ausgefällt. Der Feststoff wird abfiltriert und mit Wasser gewaschen. So erhält man 44 g (N-(p-Toluolsulfonyloxy)trimellitsäureimid mit einem Schmelzpunkt von 210-212°C.

<u>Beispiel 2:</u> 15,2 g des N-(p-Toluolsulfonyloxy)trimellitsäureimid gemäss Beispiel 1 werden in 50 ml Thionylchlorid suspendiert und 0,5 ml Dimethylformamid zugefügt. Die Mischung wird solange bei 50°C gehalten bis keine Gasbildung beobachtet wird. Die klare Lösung lässt man abkühlen und 150 ml Petrolether werden zugefügt. Die sich bildenden Kristalle werden abfiltriert, mit Petrolether gewaschen und bei 100°C im Vacuum getrocknet. Die erhaltenen 15 g N-(p-Toluolsulfonyloxy)-4-chlorcarbonylphtalimid [d.h. das Säurechlorid der Säure gemäss Beispiel 1] werden das Ethylester charakterisiert und schmelzen bei 131-133°C.

5 g des so erhaltenen Säurechlorids werden in Methylenchlorid aufgelöst und 1,8 g Hydroxyethylmethacrylat zugefügt. 1,05 g Pyridin wird langsam zugetropft. Nach 2 Stunden bei Raumtemperatur wird die Mischung noch mit Wasser, einer 2%-igen Salzsäurelösung und einer 2%-igen Natriumcarbonatlösung gewaschen. Das Produkt wird aus einer Mischung aus Methylenchlorid und Methanol auskristallisiert und ergibt 4,5 g N-(p-Toluolsulfonyloxy)-4-methacryloyloxyethoxycarbonylphtalimid mit einem Schmelzpunkt von 113°C.

<u>Beispiel 3:</u> Zu einer Lösung von 5 g N-Hydroxy-1,8-naphthalimid in 600 ml Wasser werden 2,5 g Natriumcarbonat zugefügt, was eine Rotfärbung bewirkt. Die Lösung wird filtriert und zum Filtrat werden 2 g Natriumbicarbonat und 5,25 g 4-Chlorosulfonylbenzoesäure zugegeben. Die Lösung entfärbt sich und ein Niederschlag fällt aus. Nach 2 Stunden wird angesäuert und der Niederschlag abfiltriert, mit Wasser gewaschen und über Phosphorpentoxid im Vacuum getrocknet. 7,7 g N-(4-Carboxyphenylsulfonyloxy)-1,8-naphtalimid werden aus Cyclohexan umkristallisiert. Die Kristalle schmelzen oberhalb 300°C unter Zersetzung. IR (KBr): 1720, 1700, 1680, 1580, 1370, 1190, 1000, 880, 770, 730, 700 $cm^{-1}$. NMR (Dimethylsulfoxid $d_6$) 7,4-8,6 (m-10H).

Beispiel 4: 4 g aus 3-Chlorsulfonylbenzoesäure und Thionylchlorid hergestelltes 3-Chlorsulfonylbenzoesäurechlorid werden mit einer Lösung von 2,17 g destilliertem Hydroxyethylmethacrylat in 8 g Methylenchlorid vermischt. Zu dieser Mischung werden langsam bei Raumtemperatur 1,32 g Pyridin in 2 g Methylenchlorid zugefügt. Nach 1 Stunde werden nacheinander 2,73 g N-Hydroxyphtalimid und 1,5 g Pyridin zugegeben. Nach 1 Stunde wird die Lösung nacheinander mit Wasser, einer 2%-igen Salzsäurelösung und einer 2%-igen Natriumcarbonatlösung gewaschen. Die Mischung wird über Magnesiumsulfat getrocknet und das Lösungsmittel abgedampft. N-(3-Methacryloyloxyethoxycarbonylphenylsulfonyloxy)phtalimid ist ein farbloses Oel, IR (KBr) 1800, 1750, 1720, 1400, 1300, 1270, 1200, 960, 880, 700 $cm^{-1}$; NMR (deut. Chloroform) 7,3-8,7 (m-4H), 7,9 (s-4H), 6,2 (m-1H), 4,6 (m-4H), 1,9 (s-3H).

Beispiel 5: 1 g 3-Chlorsulfonylbenzoesäurechlorid werden mit einer Lösung von 0,54 g destilliertem Hydroxyethylmethacrylat in 4 g Methylenchlorid vermischt, und langsam bei Raumtemperatur 0,33 g Pyridin in 1 g Methylenchlorid zugegeben. Nach 1 Stunde werden 1,01 g Methylolbenzoin und danach 0,35 g Pyridin zugefügt. Die Mischung wird 3 Tage gerührt, danach nacheinander mit Wasser, 2%-iger Salzsäurelösung und 2%-iger Natriumcarbonatlösung gewaschen. Die Mischung wird über Magnesiumsulfat getrocknet, mit 2,6-Di-t.-butyl-4-methylphenol stabilisiert und abgedampft. So erhält man 21 g α-(3-Methacryloyloxyethoxycarbonylphenylsulfonyloxy)methylbenzoin als farbloses Oel. IR (KBr): 3450, 3060, 2950, 1720, 1680, 1600, 1460, 1370, 1300, 1270, 1190, 1140, 1080, 1000, 990, 950, 880, 820, 750, 740, 700 $cm^{-1}$. NMR (deut. Chloroform): 7,7 (m-14H), 6,2 (s-1H), 5,6 (m-1H), 4,6 (m-4H), 2,0 (s-3H).

Beispiel 6: 16 g Natriumcarbonat werden zu einer Lösung von 16 g N-Hydroxy-1,8-naphtalimid in 600 ml Wasser gegeben. Die rote Lösung wurde abfiltriert und zum Filtrat werden 18,2 g 3-Chlorsulfonylbenzoesäurechlorid gegeben. Nach 2 Stunden Rühren wird der Niederschlag abfiltriert und in Wasser dispergiert. Die Dispersion wird

mit Salzsäure angesäuert und die Kristalle abfiltriert, mit Wasser gewaschen, im Vacuum getrocknet. So werden 27 g N-(3-Carboxyphenylsulfonyloxy)-1,8-naphtalimid erhalten.

Beispiel 7: 20 g des Produkts aus Beispiel 6 werden in 50 ml Methylenchlorid suspendiert. Danach werden 10 ml Thionylchlorid und 1 ml Dimethylformamid zugegeben und die Mischung während 4 Stunden am Rückfluss gehalten, bis kein Gas mehr entweicht. Die Mischung wird gekühlt und der entstandene Festkörper abfiltriert. Es werden 15,4 g N-(3-Chlorcarbonylphenylsulfonyloxy)-1,8-naphtalimid mit einem Schmelzpunkt von 185°C erhalten.

Zu einer Suspension von 14,75 g dieses Produkts in 50 ml Methylenchlorid werden 5,2 g Hydroxyethylmethacrylat und danach langsam 3,1 g Pyridin zugegeben. Nach 2 Stunden bei Raumtemperatur wird die Reaktionsmischung mit 200 ml Methylenchlorid verdünnt und nacheinander mit Wasser, einere 2%-igen Salzsäurelösung und einer 2%-igen Natriumcarbonatlösung gewaschen. Die Methylenchloridlösung wird über Magnesiumsulfat getrocknet, Methanol zugegeben und das Methylchlorid teilweise abgedampft. Die entstandenen Kristalle werden abfiltriert und mit Methanol gewaschen und bestehen aus 16,1 g N-(3-Methacryloyloxyethoxycarbonylphenylsulfonyloxy)-1,8-naphtylimid mit einem Schmelzpunkt von 172°C.

Beispiel 8: 4 g des Produktes gemäss Beispiel 3 werden in 10 ml Thionylchlorid suspendiert und 0,1 g Dimethylformamid werden zugegeben. Die Mischung wird während 2 Stunden auf 50°C erhitzt. Das Thionylchlorid wird teilweise abgedampft und ein kristalliner Niederschlag entsteht, welcher abfiltriert und mit Methylenchlorid gewaschen wird. So erhält man 3,3 g N-(4-Chlorcarbonylphenylsulfonyloxy)-1,8-naphtalimid mit einem Schmelzpunkt von 220°C.

1 g dieses Produkts wird zu einer Lösung von 3 g Novolakharz (erhalten aus Phenol, p-t.Butylphenol und Formaldehyd in einem molaren Verhältnis von 0,75:0,25:0,90 in Gegenwart von Oxalsäure als Katalysator. Das Harz entspricht der Formel X, worin q einen

durchschnittlichen Wert von 7,5 hat, und hat einen Erweichungspunkt von 120°C) in 6 g Pyridin gegeben. Nach 1 Stunde wird die Lösung mit Aceton verdünnt und zu 600 ml Wasser gegeben, welches 8 g konzentrierte Salzsäure enthält. Der ausfallende Niederschlag wird abfiltriert, getrocknet und in Aceton gelöst. Die Lösung wird von Spuren unlöslichen Materials abfiltriert und das Aceton abgedampft. Auf diese Weise erhält man 3,5 g modifiziertes Harz.

Beispiel 9: 2,25 g Produktes aus Beispiel 7; 1,05 g Methacrylsäure und 2,25 g Methylmethacrylat werden in 42,5 g 2-Methoxymethanol dispergiert. 0,0055 g Azobis(isobutyronitril) wird dazugegeben und die Mischung auf 10°C gekühlt und dreimal mit Stickstoff gespült. Unter Rühren wird die Mischung während 22 Stunden auf 65°C erhitzt, Die so erhaltene Copolymerlösung wird durch Filtration von unlöslichen Teilchen befreit.

Beispiel 10: Das Prozedere gemäss Beispiel 9 wird mit folgenden Materialien wiederholt: 4 g des Produkts aus Beispiel 4; 0,8 g Methacrylsäure und 3,2 g Methylmethacrylat, 32 g 2-Ethoxyethanol und 0,0048 Azobis(isobutyronitril). Dabei entsteht ebenfalls eine Polymerlösung.

Beispiel 11: Das Prozedere gemäss Beispiel 9 wird mit folgenden Verbindungen wiederholt: 3,75 g des Produkts aus Beispiel 5; 0,75 g Methacrylsäure und 3,0 g Methylmethacrylat, 42,5 g Ethoxyethanol und 0,0045 g Azobis(isobutyronitril). So erhält man die gewünschte Polymerlösung, zu welcher 200 ml Diethylether zugefügt wird, um das Copolymere auszufällen. Man erhält 2,3 g des Produkts.

Beispiel 12: 10 g (0,039 mol) 4-Nitrobenzil (hergestellt gemäss J. Chem. Soc. 1938, 1402), werden in 200 ml Dioxan gelöst. Nach Hinzufügen von 3 g Raney Nickel wird 51 Stunden bei Normaldruck und 30° unter $N_2$ hydriert ($H_2$ Aufnahme 3,72 l, 101 % der Theorie). Die gelbe Lösung wird filtriert und eingeengt, der Rückstand wird aus absolutem Alkohol umkristallisiert. Es werden 6,5 g 4-Aminobenzoin als gelbliche, wattige Nadeln erhalten, Schm. 199-203°.

Beispiel 13: Zu 524,2 g (4,5 mol) Chlorsulfonsäure wird bei 120° 586,4 g (3 mol) α,α,α-Trichlortoluol getropft. Es wird weitere 4 Stunden bei 120° und über Nacht bei 20° gerührt. Das Produkt wird nach Destillation der überschüssigen Chlorsulfonsäure abdestilliert. Eine fraktionierte Destillation ergiebt 503 g 3-Chlorsulfonylbenzoesäurechlorid als fast farblose Flüssigkeit
Sdp. (15 Torr) 153-155°C.

Beispiel 14: 24,15 g (0,101 ml) 3-Chlorsulfonyl-benzoylchlorid werden in 50 ml Methylenchlorid bei 0° unter $N_2$ vorgelegt. Dazu werden 5,91 g (0,05 mol) 1,6-Hexandiol und 10,32 g (0,102 mol) Triäthylamin in 50 ml Methylenchlorid gelöst bei 0-5° zugetropft. Nach 6 Stunden Rühren bei 20° wird filtriert und das Filtrat mit 2 x 50 ml $H_2O$, 2 x 50 ml 1N $NaHCO_3$, 1 x 50 ml gesättigter NaCl Lösung gewaschen. Die organische Phase wird über $MgSO_4$ getrocknet, filtriert und eingeengt. Der wachsartige Rückstand wird mit 800 ml Cyclohexan und 100 ml Toluol ausgekocht, nach Filtration über Kieselgur wird die klare Lösung bei -20° eingefroren und über Nacht unter Rühren wieder auftauen lassen. Vom Niederschlag wird abfiltriert. Nach Trocknung erhält man 10,8 g 1,6-Bis-(3'-chlorsulfonyl)-benzoyloxy)-hexan als weisse Kristalle (Smp. 74-76°C).

Beispiel 15: 24,15 g (0,101 mol) 3-Chlorsulfonyl-benzoylchlorid werden in 50 ml Methylenchlorid unter $N_2$ bei 0° vorgelegt. Dazu werden 6,91 g (0,05 mol) Benzol-1,4-dimethanol und 10,32 g (0,102 mol) Triaethylamin in 50 ml Tetrahydrofuran gelöst bei 0÷5° zugetropft. Nach 6 Stunden Rühren bei 20° wird filtriert, das Filtrat mit 100 ml Methylenchlorid verdünnt und mit 2 x 50 ml $H_2O$, 2 x 50 ml 1N $NaHCO_3$, 1 x 50 ml gesättigter NaCl-Lösung gewaschen. Die organische Phase wird über $MgSO_4$ getrocknet, filtriert und eingeengt. Der Rückstand wird 2 x aus Chloroform/Hexan umkristallisiert. 5.01 g Benzoldimethanol-1,4-bis(3-chlorsulfonylbenzoesäureester) weisse, feine Kristalle, Smp. 150-151°.

Beispiel 16: 1,51 g (6,66 mmol) 4-Aminobenzoin und 3,49 g des Produkts aus Beispiel 14 (6,66 mmol) werden in 33 ml THF bei 0° unter $N_2$ suspendiert. Bei 0° werden 2,25 ml (17,3 mmol) 30 % NaOH zugetropft und 6 Stunden bei 0° gerührt. Die hellgelbe Suspension auf 200 ml 1N kalte HCl giessen und 50 ml gesättigte NaCl Lösung hinzugeben. Nach Abtrennen der organischen Phase wird die wässrige Phase noch dreimal mit je 100 ml Methylenchlorid extrahiert. Die vereinigten organischen Phasen werden neutral gewaschen über $MgSO_4$ getrocknet, filtriert und eingeengt. Nach dem Trocknen bei 0,01 Torr bleibt ein gelber fester Rückstand 2,87 g (59 %) zurück.

Ein GPC in DMF mit Polystyrol als Standard ergibt ein $M_W$ von ca. 83'000. Nach GPC enthält der Rückstand noch 10-20 %

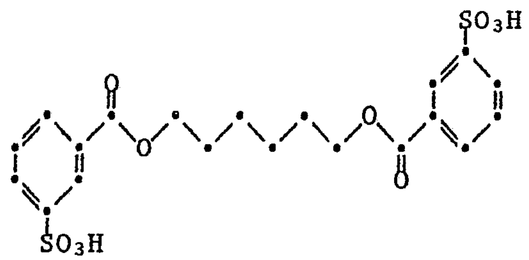

und Spuren von 4-Aminobenzoin.

Beispiel 17: 2,02 g (8,89 mmol) 4-Aminobenzoin und 4,83 g (8,89 mmol) des Produkts aus Beispiel 15 wird in 44 ml THF bei 0° unter $N_2$ suspendiert. Bei 0° werden 3,08 ml (23,11 mmol) 30 % NaOH zugetropft und 6 Stunden bei 0° gerührt. Die hellgelbe Supension auf 250 ml kalte 1N HCl giessen und 75 ml gesättigte NaCl-Lösung hinzugeben. Nach Abtrennen der organischen Phase wird die wässrige Phase noch 3 x mit je 100 ml Methylenchlorid extrahiert. Die vereinigten organischen Phasen werden neutral gewaschen, über $MgSO_4$ getrocknet, filtriert und eingeengt. Nach Trocknen bei 0,01 Torr bleibt ein gelber fester Rückstand 5,5 g (80 %) zurück.

Ein GPC mit Polystyrol als Standard, ergiebt $M_W$ von 60'000-100'000.

Beispiel 18: Zu einer 30 %-igen Lösung des Produkts aus Beispiel 8 (1,7 g) in 2-Ethoxyehtanol gibt man 5 Tropfen einer 2 %-igen Lösung von Crystal Violet in einem Lösungsmittelgemisch aus 2-Ethoxyethanol, 2-Ethoxyethylacetat und Methylethylketon in einem Volumenverhältnis von 2:2:1 zu. Diese Mischung wird auf ein gereinigtes Kupferlaminat gebracht und während 5 Minuten bei 90°C getrocknet, was eine Schichtdicke von 8 µm ergibt. Die Polymerschicht wird 1 Minute durch ein Negativ belichtet, wobei eine 5000 W Metallhalogenidlampe in einer Entfernung von 75 cm verwendet wird. Die Entwicklung mit einer 1 %-igen wässrigen Natronlaugelösung entfernt die belichteten Stellen und ergibt in 90 Sekunden ein gutes Bild.

Beispiel 19: Zur Polymerlösung aus Beispiel 10 (1,2 g) gibt man 1-Methoxycarbonylthioxanthon und 5 Tropfen der Crystal Violet-Lösung gemäss Beispiel 18 zu. Die Schicht wie in Beispiel 18 aufgetragen beträgt 7 µm. Diese wird wie in Beispiel 18 beschrieben, belichtet. Die Entwicklung erfolgt mit einer 0,5 %-igen wässrigen Natronlaugelösung, welche 10 Vol-% enthält. Auf diese Weise wird ein gutes Bild in 1 Minute erhalten.

Beispiel 20: Wie in Beispiel 18 beschrieben wird ein kupferbeschichtetes Laminat mit der Copolymer-Lösung aus Beispiel 9 (1,2 g) beschichtet, getrocknet und die 8 µm dicke Schicht belichtet. Die Entwicklung erfolgt mit einer 2 %-igen wässrigen Natronlaugelösung, welche 10 Vol-% Aceton enthält und man erhält so ein gutes Bild in 2 Minuten.

Beispiel 21: Wie in Beispiel 18 beschrieben wird ein kupferbeschichtetes Laminat mit 1,2 g der Copolymerenlösung aus Beispiel 11 beschichtet, die 5 µm dicke Schicht belichtet und entwickelt. Man erhält ein gutes Bild in 2 Minuten.

Beispiel 22: Eine Lösung des Polymeren gemäss Beispiel 16 wird mittels eines Rakels (40 µm Nassfilmdicke) auf ein anodisiertes und elektrolytisch aufgerauhtes Aluminiumblech (Offsetplattensubstrat) beschichtet und 25 Minuten bei 80° getrocknet (Schichtdicke ca.

10 µm). Es wird durch eine Maske bildmässig belichtet (Lichtquelle 5000 W Metall-Halogenlampe, Sylvania M 061, Abstand zum Vakuumrahmen 65 cm). Die belicheten Stellen werden in einem alkalischen Bad (C1290, Hotsell Graphic Industries, Morley/GB, 1:1 mit Wasser verdünnt) herausgelöst und man erhält ein positives Bild.

Patentansprüche

1. Polymer mit einem Molekulargewicht von mindestens 500, welches mindestens eine Gruppe der Formel I enthält

$$(-L^1-)_m Ar^1[X]-OSO_2-Ar^2(-L^2-)_n \qquad (I)$$

worin einer der Indices m und n 1 ist und der andere 0 oder 1 bedeutet und X eine Gruppe der Formel II

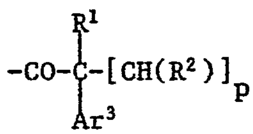

(II)

bedeutet, welche über die Carbonylgruppe an ein C-Atom der Gruppe $Ar^1$ verknüpft ist, oder X eine Gruppe der Formel III ist

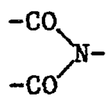

(III)

welche über die beiden Carbonylgruppen mit dem Rest $Ar^1$ verknüpft ist, und p 0 oder 1 bedeutet, und $R^1$, falls p 0 ist, Wasserstoff oder eine einwertige aliphatische, araliphatische oder aromatische Gruppe ist, und $R^1$, falls p 1 ist, Wasserstoff, -OH, oder eine veretherte -OH Gruppe, eine Acyloxygruppe, Alkyl oder Phenylalkyl bedeutet, und $R^2$ Wasserstoff oder eine einwertige aliphatische, cycloaliphatische, heterocyclische, aromatische oder araliphatische Gruppe bedeutet, und $Ar^1$ eine ein-, zwei- oder dreiwertige aromatische Gruppe ist, und $Ar^2$ eine ein- oder zweiwertige aromatische Gruppe ist und $Ar^3$ eine einwertige aromatische Gruppe bedeutet und $L^1$ und $L^2$ unabhängig voneinander -CO-, -COO-, -CONH-, -OCOO-, -NHCONH-, -OCONH-, -CSS-, -OCSS-, $-OSO_2-$, $-CH_2-$, -CH=, -O-, -S- oder -N= bedeuten.

2. Polymere gemäss Anspruch 1, welche Gruppen der Formel I enthalten, worin X eine Gruppe der Formel II bedeutet und p 0 bedeutet, $R^1$ Wasserstoff, $C_1$-$C_8$ Alkyl welches unsubstituiert oder mit -OH, -Cl, -CN, $C_1$-$C_4$ Alkoxy, $C_2$-$C_5$ Alkoxycarbonyl, Phenyl, Chlorphenyl,

$C_7$-$C_{10}$ Alkylphenyl oder $C_7$-$C_{10}$ Alkoxyphenyl substituiert ist, ferner Phenyl, welches unsubstituiert oder mit -Cl, -$C_1$-$C_4$ Alkyl, $C_1$-$C_4$-Alkoxy oder $C_1$-$C_4$ Alkylthio substituiert ist, ferner Benzoyl, $C_2$-$C_8$ Alkoxycarbonyl, $C_1$-$C_4$ Alkyl-NHCO-, Phenyl-NHCO-, -$CONH_2$ oder -CN; und $Ar^1$ und $Ar^2$ unabhängig voneinander eine ein- oder zweiwertige aromatische Gruppe mit 6-30 C-Atomen ist, wobei mindestens eine der Gruppen $Ar^1$ oder $Ar^2$ zweiwertig ist, und $Ar^3$ Phenyl, welches unsubstituiert oder mit -Cl, $C_1$-$C_4$ Alkyl, $C_1$-$C_4$ Alkoxy oder $C_1$-$C_4$ Alkylthio substituiert ist.

3. Polymere gemäss Anspruch 2, wobei X eine Gruppe der Formel II ist, p 0 bedeutet und $R^1$ Wasserstoff oder $C_1$-$C_4$ Alkyl ist, und $Ar^1$ und $Ar^2$ Phenyl oder Phenylen bedeutet, und mindestens eines von $Ar^1$ und $Ar^2$ Phenylen ist, und $Ar^3$ Phenyl bedeutet.

4. Polymere gemäss Anspruch 1, welche Gruppen der Formel I enthalten, worin X eine Gruppe der Formel II ist, p 1 bedeutet, und $R^1$ Wasserstoff, -OH, $C_1$-$C_4$ Alkoxy, Acetyloxy, $C_1$-$C_8$ Alkyl oder $C_7$-$C_{14}$ Phenylalkyl ist. $R^2$ Wasserstoff, $C_1$-$C_8$ Alkyl, welches unsubstituiert oder mit -OH, -Cl oder Phenyl substituiert ist, oder ferner Phenyl, welches unsubstituiert oder mit -OH, -Cl, $C_1$-$C_4$ Alkyl, $C_1$-$C_4$ Alkoxy substituiert ist, oder $R^2$ ausserdem $C_2$-$C_6$ Alkenyl, $C_8$-$C_9$ Phenylalkenyl, Furyl, $C_5$-$C_6$ Cycloalkyl oder $C_5$-$C_6$ Cycloalkenyl ist, und $Ar^1$ und $Ar^2$ unabhängig voneinander eine ein- oder zweiwertige Gruppe mit 6-30 C-Atomen ist, und mindestens eine der Gruppen $Ar^1$ oder $Ar^2$ zweiwertig ist, und $Ar^3$ Phenyl, welches unsubstituiert oder mit -Cl, $C_1$-$C_4$ Alkyl, $C_1$-$C_4$ Alkoxy oder $C_1$-$C_4$ Alkylthio substituiert ist.

5. Polymere gemäss Anspruch 4, wobei $R^1$ -OH, $C_1$-$C_4$ Alkyl oder $C_1$-$C_4$ Alkoxy und $R^2$ Wasserstoff oder $C_1$-$C_4$ Alkyl sind, und $Ar^1$ und $Ar^2$ unabhängig voneinander Phenyl, Naphtyl, Phenylen oder Naphtylen sind, welche unsubstituiert oder mit -Cl, -Br, -CN, -$NO_2$, $C_1$-$C_{12}$ Alkyl, $C_1$-$C_4$ Alkoxy oder $C_1$-$C_8$ Alkylthio substituiert sind und mindestens eines von $Ar^1$ und $Ar^2$ unsubstituiertes oder substituiertes Phenylen oder Naphtylen sind.

6. Polymere gemäss Anspruch 4, wobei $R^1$ -OH oder $C_1$-$C_4$ Alkoxy ist, und $R^2$ Wasserstoff ist, und $Ar^1$ und $Ar^2$ unabhängig voneinander Phenyl oder Phenylen sind und mindestens eines von $Ar^1$ und $Ar^2$ Phenylen ist, und $Ar^3$ Phenyl ist.

7. Polymere gemäss Anspruch 2, worin die Gruppe der Formel I der Formel IV entspricht

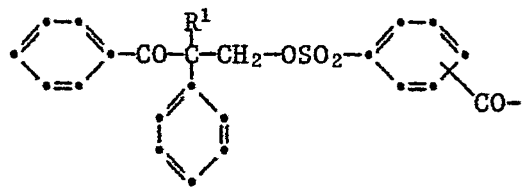

(IV)

worin $R^1$ -OH oder $C_1$-$C_4$ Alkoxy ist und die Carbonylgruppe mit der freien Valenz bevorzugt in para-Stellung zur Sulfonyloxygruppe steht.

8. Polymere gemäss Anspruch 1, wobei in der Formel I X eine Gruppe der Formel III bedeutet und $Ar^1$ eine zweiwertige falls m 1 ist eine dreiwertige aromatische Gruppe mit 6-30 C-Atomen, und $Ar^2$ eine ein-oder zweiwertige aromatische Gruppe mit 6-30 C-Atomen.

9. Polymere gemäss Anspruch 8, wobei $Ar^1$ o-Phenylen; 1,2-, 2,3- oder 1,8-Naphtylen oder Benzol-1,2,3-, -1,2,4-, -1,2,5- oder -1,2,6-triyl bedeutet, wobei diese Reste unsubstituiert oder mit -Cl, -Br, $-NO_2$, $-C_1$-$C_8$ Alkyl, $C_1$-$C_4$ Alkoxy, $C_1$-$C_{12}$ Alkylthio oder Phenylthio substituiert sind, und $Ar^2$ Phenyl, m- oder p-Phenylen, Naphtyl oder 1,2-, 2,3- oder 1,8-Naphtylen bedeutet, wobei diese Reste substituiert oder mit -Cl, -Br, $-NO_2$, $C_1$-$C_{15}$ Alkyl, $C_1$-$C_4$ Alkoxy, $C_1$-$C_4$ Alkyl-CONH oder Phenyl-CONH substituiert sind.

10. Polymere gemäss Anspruch 9, in welchen $Ar^1$ o-Phenylen, 1,8-Naphtylen oder Benzol-1,2,4-triyl bedeutet, und $Ar^2$ Phenyl, p-Tolyl oder m- oder p-Phenylen ist.

11. Polymer gemäss Anspruch 10, in welchen der Rest der Formel I einer Formel V, VI oder VII entspricht

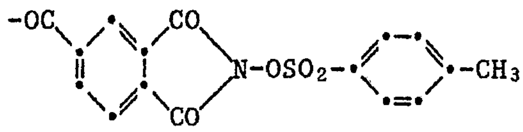 (V)

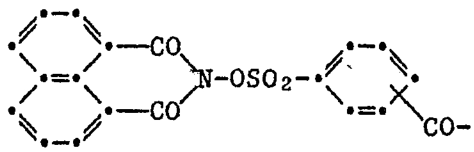 (VI)

oder

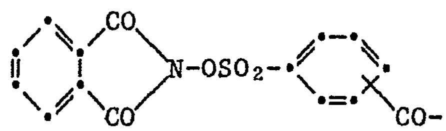 (VII)

wobei die Carbonylgruppe mit der freien Valenz in den Formeln VI und VII in m- oder p-Stellung stehen.

12. Polymer gemäss Anspruch 1, in welchen einer der Indices m und n 0 ist und der andere 1 bedeutet, und der Rest der Formel I direkt oder über ein organisches Brückenglied an die Polymerkette verknüpft ist.

13. Polymer gemäss Anspruch 1, welches ein Copolymer ist, erhältlich aus

(a) einem Monomeren der Formel XI
$CH_2=C(R^7)COOR^6-OY$ (XI)
worin $R^7$ Wasserstoff oder Methyl ist, und Y eine Gruppe der Formel I bedeutet, worin einer der Indices m und n 0 und der andere 1 ist, und $R^6$ die oben angegebene Bedeutung hat, und

(b) einer polymerisierbaren ethylenisch ungesättigten Säure und gegebenenfalls

(c) einem weiteren ethylenisch ungesättigten Monomer.

14. Polymer gemäss Anspruch 1, welches ein Polyester oder Polyamid ist, und die Gruppen der Formel als wiederkehrende Einheit besitzen, und m und n 1 bedeuten.

15. Verbindungen der Formel XII

$$(HOOC)_m Ar^1-[X]-OSO_2-Ar^2(COOH)_n \qquad (XII),$$

worin einer Indices m und n 0 oder 1 ist, und der 1 bedeutet, und $Ar^1$ und $Ar^2$ die in Anspruch 1 angegebene Bedeutung haben und X eine Gruppe der Formel II ist, oder X eine Gruppe der Formel III ist, falls m und n 1 sind oder m 0 ist und n 1 bedeutet.

16. Verbindungen der Formel XI

$$CH_2=C(R^7)COO-R^6-OY \qquad (XI),$$

worind $R^6$ $C_1$-$C_8$ Alkylen bedeutet, welches durch eine Hydroxylgruppe substituiert sein kann, und $R^7$ und Y die in Anspruch 13 angegebene Bedeutung haben.

17. Verfahren zur Erzeugung von Bildern, dadurch gekennzeichnet, dass man

(i) eine Schicht eines organischen Polymers enthaltend photosensitive Reste, welche (a) eine über Sauerstoff an ein aliphatisches C-Atom gebundene Sulfonyloxygruppe enthalten, wobei das C-Atom in α- oder β-Stellung zu einer Carbonylgruppe steht, welche ihrerseits in α- oder β-Stellung zu einer aromatischen Gruppe steht, oder (b) eine über die Carbonylgruppe oder das Schwefelatom direkt an die aromatische Gruppe verknüpfte Sulfonyloxyimidgruppe enthalten,
in einem vorgegebenen Muster mit aktinischem Licht bestrahlt, wodurch das Polymer an den belichteten Stellen in wässrigen basischen Entwicklern löslicher wird als an unbelichteten Stellen, und

(ii) das Polymer an den bestrahlten Stellen durch Behandlung mit dem wässrigen basischen Entwickler entfernt.

18. Polymer gemäss Anspruch 1, welches ein phenolisches Novolakharz ist, in welchem mindestens 4 % der phenolischen Hydroxygruppen durch eine -OY ersetzt sind, wobei Y eine Gruppe der Formel I bedeutet, worin eine der Indices m und n 1 und der andere 0 bedeutet und $L^1$ und $L^2$ -CO- sind.

19. Polymer gemäss Anspruch 18 der Formel

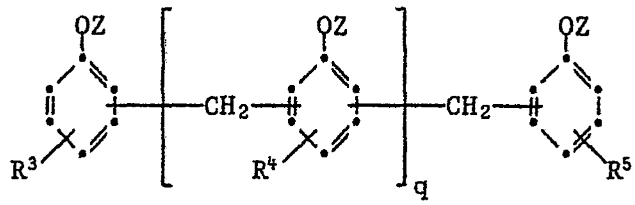 (X),

worin Z Wasserstoff oder Y bedeutet, und mindestens 4 % aller Reste Z per Molekül Y bedeuten, $R^3$, $R^4$ und $R^5$ unabhängig voneinander Wasserstoff, Chlor, Brom, $C_1$-$C_{10}$ Alkyl, $C_7$-$C_{20}$ Aralkyl, Acetyl, Benzoyl, Carboxyl, verestertes Carboxyl oder -OZ bedeuten, und q eine ganze Zahl von 1 bis 20 ist.

20. Polymer gemäss Anspruch 19, worin Y ein Rest der Formeln IV, V, VI oder VII ist.

FO 7.3 HPS/we*/cw*/sm*